(19) Europäisches Patentamt / European Patent Office / Office européen des brevets

(11) **EP 3 781 954 B1**

(12) **FASCICULE DE BREVET EUROPEEN**

(45) Date de publication et mention de la délivrance du brevet:
**31.05.2023 Bulletin 2023/22**

(21) Numéro de dépôt: **19717930.2**

(22) Date de dépôt: **18.04.2019**

(51) Classification Internationale des Brevets (IPC):
**G01R 21/133** *(2006.01)*

(52) Classification Coopérative des Brevets (CPC):
**G01R 21/133**

(86) Numéro de dépôt international:
**PCT/EP2019/060074**

(87) Numéro de publication internationale:
**WO 2019/202075 (24.10.2019 Gazette 2019/43)**

(54) **COMPTEUR D'ÉNERGIE ÉLECTRIQUE COMPORTANT UN CIRCUIT DE MESURE DE COURANT ET UN CIRCUIT DE MESURE DE TENSION**

ELEKTRISCHER ENERGIEZÄHLER MIT EINER STROMMESSSCHALTUNG UND EINER SPANNUNGSMESSSCHALTUNG

ELECTRICAL ENERGY METER COMPRISING A CURRENT-MEASURING CIRCUIT AND A VOLTAGE-MEASURING CIRCUIT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.04.2018 FR 1853525**

(43) Date de publication de la demande:
**24.02.2021 Bulletin 2021/08**

(73) Titulaire: **Sagemcom Energy & Telecom SAS**
**92500 Rueil-Malmaison (FR)**

(72) Inventeur: **TEBOULLE, Henri**
**92500 RUEIL MALMAISON (FR)**

(74) Mandataire: **Lavaud, Thomas et al**
**Cabinet Boettcher**
**16, rue Médéric**
**75017 Paris (FR)**

(56) Documents cités:
| | |
|---|---|
| WO-A1-01/55733 | WO-A1-2018/022552 |
| CN-A- 103 869 210 | CN-A- 107 037 261 |
| GB-A- 2 347 225 | US-A1- 2003 036 864 |
| US-A1- 2008 215 262 | US-A1- 2012 169 300 |
| US-A1- 2014 218 008 | US-A1- 2017 184 697 |

**Description**

L'invention concerne le domaine des compteurs d'énergie électrique comportant un circuit de mesure de courant et un circuit de mesure de tension. La publication de la demande de brevet US 2008/215262 A1 divulgue un exemple de tels compteurs.

ARRIERE PLAN DE L'INVENTION

Les compteurs d'énergie électrique de classe D, destinés à un usage industriel lourd, mesurent classiquement des courants d'intensité très importante, parfois supérieure à 1000 A.

Un tel compteur est donc généralement connecté à un ou plusieurs conducteurs de phase d'un réseau de distribution via un ou des transformateurs externes montés sur les conducteurs de phase. Ces transformateurs externes présentent typiquement un rapport de transformation compris entre 100 et 1000.

Dans un compteur relié à un réseau de distribution via un transformateur externe, il convient d'isoler électriquement des composants de mesure de courant destinés à mesurer un ou des courants de phase circulant sur le ou les conducteurs de phase, et des composants de mesure de tension destinés à mesurer une ou des tensions de phase sur le ou les conducteurs de phase. En effet, pour chaque conducteur de phase, la tension de phase est acquise directement sur le conducteur de phase, alors que le courant de phase est acquis via le transformateur externe. Les composants de mesure de courant et les composants de mesure de tension sont donc isolés de manière indépendante et distincte, et il peut exister des différences de potentiel importantes entre leur référence de masse.

Un tel compteur doit par ailleurs être conforme à des exigences de précision relativement contraignantes. La précision à atteindre pour un compteur de classe D est typiquement égale à ±0,2%.

Pour répondre à ces exigences d'isolation et de précision, les concepteurs de compteurs ont aujourd'hui le choix entre deux solutions connues.

Une première solution consiste à utiliser, dans les composants de mesure de courant, un ou des capteurs de Rogowski. Il est alors très compliqué de mettre le compteur en conformité avec les exigences d'immunité aux perturbations dans une gamme de fréquence comprise entre 2kHz et 150kHz. En effet, les capteurs de Rogowski sont des dérivateurs de courant et, une fois dérivées, de telles perturbations ont une amplitude proportionnelle à leur fréquence.

Une deuxième solution consiste à utiliser, dans les composants de mesure de courant, des transformateurs de courant internes auxquels on connecte des capteurs de courant relativement précis. Cependant, de tels transformateurs de courant internes présentent une dérive en température. La compensation de cette dérive en température, pour tenir les exigences de précision associées à un compteur de classe D, est complexe à réaliser.

On note aussi que la première solution et la deuxième solution sont généralement mises en oeuvre à l'aide de composants principalement analogiques, qui tendent à dériver dans le temps.

OBJET DE L'INVENTION

L'invention a pour objet un compteur d'énergie électrique conforme à l'exigence de précision classiquement associée aux compteurs de classe D.

RESUME DE L'INVENTION

En vue de la réalisation de ce but, on propose un compteur d'énergie électrique comportant un circuit de mesure de courant agencé pour mesurer un courant de phase circulant sur un conducteur de phase d'un réseau de distribution et un circuit de mesure de tension agencé pour mesurer une tension de phase sur le conducteur de phase, le circuit de mesure de courant comprenant un capteur de courant produisant une première tension de mesure analogique représentative du courant de phase et un premier convertisseur analogique numérique agencé pour réaliser un premier échantillonnage de la première tension de mesure analogique de manière à produire des premières valeurs numériques, le circuit de mesure de tension comprenant un capteur de tension produisant une deuxième tension de mesure analogique représentative de la tension de phase et un deuxième convertisseur analogique numérique agencé pour réaliser un deuxième échantillonnage de la deuxième tension de mesure analogique de manière à produire des deuxièmes valeurs numériques, le compteur d'énergie électrique comprenant en outre un premier circuit de synchronisation agencé pour synchroniser en fréquence le premier échantillonnage et le deuxième échantillonnage.

La synchronisation en fréquence du premier échantillonnage de la première tension de mesure analogique représentative du courant de phase, et du deuxième échantillonnage de la deuxième tension de mesure analogique représentative de la tension de phase, permet d'obtenir des premières valeurs numériques et des deuxièmes valeurs numériques synchronisées en fréquence.

On améliore ainsi la précision de l'estimation de la puissance et donc de la quantité d'énergie électrique consommée par l'installation dans laquelle est intégré le compteur d'énergie électrique.

On propose aussi un compteur d'énergie électrique tel que celui qui vient d'être décrit, dans lequel le circuit de mesure de courant comprend un module de mesure de courant qui comprend le capteur de courant et qui est isolé électriquement du circuit de mesure de tension.

Dans un mode de réalisation particulier, l'isolation électrique entre le module de mesure de courant et le circuit de mesure de tension est assurée par une barrière d'isolation intégrée dans le premier convertisseur analogique numérique.

Ainsi, on obtient une isolation électrique du module de mesure de courant et du circuit de mesure de tension qui ne nécessite pas d'utiliser un capteur de Rogowski ou un transformateur de courant interne, et qui ne présente donc pas les inconvénients associés à ces solutions.

Dans un mode de réalisation particulier, le capteur de courant comprend un *shunt* et le capteur de tension comprend un pont diviseur de tension.

L'utilisation d'un *shunt*, ou de plusieurs *shunts* dans le cas d'un compteur polyphasé, permet de traiter dans de bonnes conditions les perturbations dans une gamme de fréquence comprise entre 2kHz et 150kHz. Par ailleurs, les *shunts* sont peu sensibles aux variations de température.

On note que, dans le compteur d'énergie électrique selon l'invention, les mesures sont traitées principalement par des composants numériques (premier convertisseur analogique numérique, deuxième convertisseur analogique numérique éventuellement intégré dans un composant de traitement numérique, etc.) qui subissent très peu de dérives dans le temps.

L'invention sera mieux comprise à la lumière de la description qui suit d'un mode de mise en œuvre particulier non limitatif de l'invention.

BREVE DESCRIPTION DES DESSINS

Il sera fait référence aux dessins annexés, parmi lesquels :

- la figure 1 est un schéma électrique du compteur d'énergie électrique selon l'invention ;
- la figure 2 représente des étapes de calibration du compteur d'énergie électrique selon l'invention.

DESCRIPTION DETAILLEE DE L'INVENTION

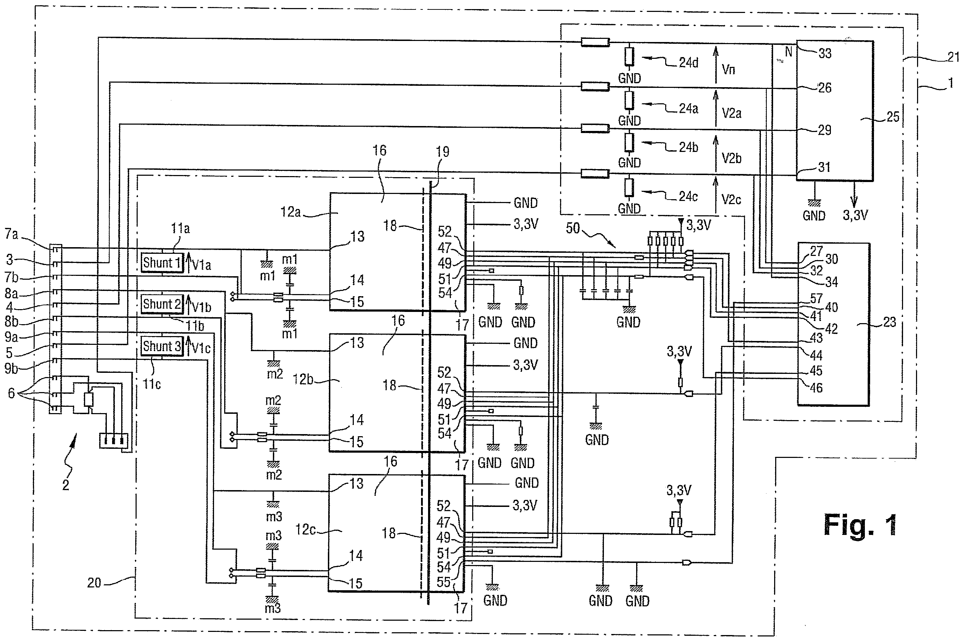

En référence à la figure 1, le compteur d'énergie électrique selon l'invention 1 est ici un compteur d'énergie électrique triphasé industriel. Le compteur est un compteur de classe D.

Le compteur 1 est destiné à mesurer une quantité d'énergie électrique fournie à une installation électrique industrielle par un réseau de distribution triphasé.

Le compteur 1 est connecté à un premier conducteur de phase du réseau via un premier transformateur externe comprenant un primaire ayant des bornes connectées au premier conducteur de phase, à un deuxième conducteur de phase du réseau via un deuxième transformateur externe comprenant un primaire ayant des bornes connectées au deuxième conducteur de phase, et à un troisième conducteur de phase du réseau via un troisième transformateur externe comprenant un primaire ayant des bornes connectées au troisième conducteur de phase. Le compteur 1 est aussi connecté à un conducteur de neutre du réseau.

Le compteur 1 comporte tout d'abord un bornier 2 comprenant un premier port de tension 3, un deuxième port de tension 4, un troisième port de tension 5, des ports de neutre 6, un premier port de courant amont 7a, un premier port de courant aval 7b, un deuxième port de courant amont 8a, un deuxième port de courant aval 8b, un troisième port de courant amont 9a et un troisième port de courant aval 9b.

Lorsque le compteur 1 est connecté au réseau, le premier port de tension 3 est relié au premier conducteur de phase, le deuxième port de tension 4 est relié au deuxième conducteur de phase, et le troisième port de tension 5 est relié au troisième conducteur de phase.

Un secondaire du premier transformateur externe présente une première borne reliée au premier port de courant amont 7a et une deuxième borne reliée au premier port de courant aval 7b, un secondaire du deuxième transformateur externe présente une première borne reliée au deuxième port de courant amont 8a et une deuxième borne reliée au deuxième port de courant aval 8b, et un secondaire du troisième transformateur externe présente une première borne reliée au troisième port de courant amont 9a et une deuxième borne reliée au troisième port de courant aval 9b. Les ports de neutre 6 sont reliés au conducteur de neutre du réseau.

Le compteur 1 comporte de plus un circuit de mesure de courant 20.

Le circuit de mesure de courant 20 comprend trois capteurs de courant, en l'occurrence trois *shunts* 11, et trois premiers convertisseurs analogiques numériques 12.

Un premier *shunt* 11a est connecté entre le premier port de courant amont 7a et le premier port de courant aval 7b. Un deuxième *shunt* 11b est connecté entre le deuxième port de courant amont 8a et le deuxième port de courant aval 8b. Un troisième *shunt* 11c est connecté entre le troisième port de courant amont 9a et le troisième port de courant aval 9b.

Une première tension de mesure analogique V1a est générée aux bornes du premier *shunt* 11a. La première tension de mesure analogique V1a est représentative d'un premier courant de phase circulant sur le premier conducteur de phase. Un premier convertisseur analogique numérique 12a comporte une première patte d'entrée 13 et une deuxième patte d'entrée 14 reliées à une première borne du premier *shunt* 11a, et une troisième patte d'entrée 15 reliée à une deuxième borne du premier *shunt* 11a. Par patte, on traduit ici le mot anglais « pin ». Une patte est donc ici une « pin » d'un composant quelconque (convertisseur analogique numérique, microcontrôleur, etc.), quel que soit le type de boîtier du composant.

Le premier convertisseur analogique numérique 12a utilise une première référence de masse m1 prise sur un conducteur reliant le premier port de courant amont 7a, une borne du premier *shunt* 11a, et la première entrée 13 du premier convertisseur analogique numérique 12a.

Une première tension de mesure analogique V1b est générée aux bornes du deuxième *shunt* 11b. La première tension de mesure analogique V1b est représentative d'un deuxième courant de phase circulant sur le deuxième conducteur de phase. Un premier convertisseur analogique numérique 12b comporte une première patte d'entrée 13 et une deuxième patte d'entrée 14 reliées à une première borne du deuxième *shunt* 11b, et une troisième patte d'entrée 15 reliée à une deuxième borne du deuxième *shunt* 11b. Le premier convertisseur analogique numérique 12b utilise une deuxième référence de masse m2 prise sur un conducteur reliant le deuxième port de courant amont 8a, une borne du deuxième *shunt* 11b, et la première entrée 13 du premier convertisseur analogique numérique 12b.

Une première tension de mesure analogique V1c est générée aux bornes du troisième *shunt* 11c. La troisième tension de mesure analogique V1c est représentative d'un troisième courant de phase circulant sur le troisième conducteur de phase. Un premier convertisseur analogique numérique 12c comporte une première patte d'entrée 13 et une deuxième patte d'entrée 14 reliées à une première borne du troisième *shunt* 11c, et une troisième patte d'entrée 15 reliée à une deuxième borne du troisième *shunt* 11c. Le premier convertisseur analogique numérique 12c utilise une troisième référence de masse m3 prise sur un conducteur reliant le troisième port de courant amont 9a, une borne du troisième *shunt* 11c, et la première entrée 13 du premier convertisseur analogique numérique 12c.

La première référence de masse m1, la deuxième référence de masse m2 et la troisième référence de masse m3 sont distinctes et isolées entre elles.

Chaque premier convertisseur analogique numérique 12 acquiert une première tension de mesure analogique V1 appliquée entre sa deuxième patte d'entrée 14 et sa troisième patte d'entrée 15, et réalise un premier échantillonnage de la première tension de mesure analogique V1 de manière à obtenir des premières valeurs numériques.

Les trois premiers convertisseurs analogiques numériques 12 sont ici des convertisseurs sigma delta. Un exemple de référence pouvant être utilisée pour les premiers convertisseurs analogiques numériques 12 est la référence ADE7912 (*Analog Device*).

Chaque premier convertisseur analogique numérique 12 comporte un étage d'entrée 16 et un étage de sortie 17 isolés par une barrière d'isolation 18. La barrière d'isolation 18 comprend un transformateur d'isolation présentant un entrefer d'environ 8mm. La barrière d'isolation 18 est efficace pour des tensions jusqu'à 5kVAC RMS.

Une barrière d'isolation globale 19 est donc définie par les barrières d'isolation 18 des trois premiers convertisseurs analogiques numériques 12. La barrière d'isolation globale 19 isole ainsi électriquement un module de mesure de courant et un module de sortie.

Le module de mesure de courant est situé en amont de la barrière d'isolation globale 19 (du côté du réseau), et le module de sortie est situé en aval de la barrière d'isolation globale 19 (du côté de l'installation électrique industrielle).

Le module de mesure de courant comporte les trois *shunts* 11 et les étages d'entrée 16 des trois premiers convertisseurs analogiques numériques 12. Le module de sortie comporte les étages de sortie 17 des trois premiers convertisseurs analogiques numériques 12.

Le compteur 1 comporte de plus un circuit de mesure de tension 21.

Le circuit de mesure de tension 21 comprend un composant de traitement dans lequel est intégré un deuxième convertisseur analogique numérique, des capteurs de tension, en l'occurrence quatre ponts diviseurs de tension 24, et un composant d'alimentation 25.

Le composant de traitement est ici un microcontrôleur 23, mais pourrait être un composant différent, par exemple un FPGA. Un exemple de référence pouvant être utilisée pour le microcontrôleur 23 est la référence STM32F105 (STMicroelectronics).

Le microcontrôleur 23 et le composant d'alimentation 25 utilisent une quatrième référence de masse GND définie à l'intérieur du compteur 1 (et isolée des références de masse m1, m2 et m3).

Une première patte d'entrée 26 du composant d'alimentation 25 et une première patte d'entrée 27 du microcontrôleur 23 sont reliées au premier port de tension 3 via un premier pont diviseur de tension 24a comprenant deux résistances. Le premier pont diviseur de tension 24a utilise la quatrième référence de masse GND.

Une deuxième patte d'entrée 29 du composant d'alimentation 25 et une deuxième patte d'entrée 30 du microcontrôleur 23 sont reliées au deuxième port de tension 4 via un deuxième pont diviseur de tension 24b comprenant deux résistances. Le deuxième pont diviseur de tension 24b utilise la quatrième référence de masse GND.

Une troisième patte d'entrée 31 du composant d'alimentation 25 et une troisième patte d'entrée 32 du microcontrôleur 23 sont reliées au troisième port de tension 5 via un troisième pont diviseur de tension 24c comprenant deux résistances. Le troisième pont diviseur de tension 24c utilise la quatrième référence de masse GND.

Une quatrième patte d'entrée 33 du composant d'alimentation 25 et une quatrième patte d'entrée 34 du microcontrôleur 23 sont reliées à l'un des ports de neutre 6 via un quatrième pont diviseur de tension 24d comprenant deux résistances. Le quatrième pont diviseur de tension 24d utilise la quatrième référence de masse GND.

Une deuxième tension de mesure analogique V2a est générée en sortie du premier pont diviseur de tension 24a. La deuxième tension de mesure analogique V2a est représentative d'une première tension de phase sur le premier conducteur de phase. Le microcontrôleur 23 acquiert et transmet au deuxième convertisseur analogique numérique la deuxième tension de mesure analogique V2a.

Une deuxième tension de mesure analogique V2b est générée en sortie du deuxième pont diviseur de tension 24b. La deuxième tension de mesure analogique V2b est représentative d'une deuxième tension de phase sur le deuxième conducteur de phase. Le microcontrôleur 23 acquiert et transmet au deuxième convertisseur analogique numérique la deuxième tension de mesure analogique V2b.

Une deuxième tension de mesure analogique V2c est générée en sortie du troisième pont diviseur de tension 24c. La deuxième tension de mesure analogique V2c est représentative d'une troisième tension de phase sur le troisième conducteur de phase. Le microcontrôleur 23 acquiert et transmet au deuxième convertisseur analogique numérique la deuxième tension de mesure analogique V2c.

Une tension de mesure analogique de neutre Vn est générée en sortie du quatrième pont diviseur de tension 24d. La tension de mesure analogique de neutre Vn est représentative de la tension de neutre. Le microcontrôleur 23 acquiert et transmet au deuxième convertisseur analogique numérique la tension de mesure analogique de neutre Vn.

Le deuxième convertisseur analogique numérique acquiert donc les deuxièmes tensions de mesure analogiques V2, et réalise un deuxième échantillonnage de chaque deuxième tension de mesure analogique V2 de manière à obtenir des deuxièmes valeurs numériques.

Le composant d'alimentation 25 utilise les deuxièmes tensions de mesure analogiques V2 pour produire une tension d'alimentation ici égale à 3,3V. La tension d'alimentation alimente notamment le microcontrôleur 23 et les trois premiers convertisseurs analogiques numériques 12 (via leur étage de sortie 17).

On note que le module de mesure de courant du circuit de mesure de courant 20 et le circuit de mesure de tension 21 sont isolés électriquement par la barrière d'isolation globale 19.

On décrit maintenant les connexions électriques entre le microcontrôleur 23 et les trois premiers convertisseurs analogiques numériques 12.

Le microcontrôleur 23 comporte une patte SCK 40 (pour *SPI Clock*), une patte MISO 41 (pour Master Input, Slave Output), une patte MOSI 42 (pour Master Output, Slave Input), une patte CS1 43 (pour *Chip Select* 1), une patte CS2 44 (pour *Chip Select* 2), une patte CS3 45 (pour *Chip Select* 3), une patte CLK 46 (pour *Clock*) et une patte de cadence 57.

La patte SCK 40 du microcontrôleur 23 est reliée à une patte SCLK 47 du premier convertisseur analogique numérique 12a, à une patte SCLK 47 du premier convertisseur analogique numérique 12b, et à une patte SCLK 47 du premier convertisseur analogique numérique 12c.

La patte MISO 41 du microcontrôleur 23 est reliée à une patte MISO 49 du premier convertisseur analogique numérique 12a, à une patte MISO 49 du premier convertisseur analogique numérique 12b, et à une patte MISO 49 du premier convertisseur analogique numérique 12c.

La patte MOSI 42 du microcontrôleur 23 est reliée à une patte MOSI 51 du premier convertisseur analogique numérique 12a, à une patte MOSI 51 du premier convertisseur analogique numérique 12b, et à une patte MOSI 51 du premier convertisseur analogique numérique 12c.

La patte CS1 43 du microcontrôleur 23 est reliée à une patte CS 52 du premier convertisseur analogique numérique 12a, la patte CS2 44 du microcontrôleur 23 est reliée à une patte CS 52 du premier convertisseur analogique numérique 12b, et la patte CS3 45 du microcontrôleur 23 est reliée à une patte CS 52 du premier convertisseur analogique numérique 12c.

Ainsi, le microcontrôleur 23 et les trois premiers convertisseurs analogiques numériques 12 sont reliés par un bus numérique, en l'occurrence un bus SPI 50.

La patte CLK 46 du microcontrôleur 23 est reliée à une patte de synchronisation 54 du premier convertisseur analogique numérique 12a, à une patte de synchronisation 54 du premier convertisseur analogique numérique 12b, et à une patte de synchronisation 54 du premier convertisseur analogique numérique 12c.

Une patte de disponibilité 55 du premier convertisseur analogique numérique 12c est reliée à la patte de cadence 57 du microcontrôleur 23.

Les trois premiers convertisseurs analogiques numériques 12 sont synchronisés en fréquence par le microcontrôleur 23 via le bus SPI 50. Le microcontrôleur 23 produit un signal d'horloge sur sa patte CLK 46. La fréquence du signal d'horloge est ici égale à 4MHz (mais pourrait bien sûr être différente). Les trois premiers convertisseurs analogiques numériques 12 utilisent le signal d'horloge pour cadencer le premier échantillonnage qu'ils mettent chacun en oeuvre, de sorte que les trois premiers convertisseurs analogiques numériques 12 sont synchronisés entre eux en fréquence.

De plus, le microcontrôleur 23 émet une commande de synchronisation sur sa patte CS1 43, sa patte CS2 44 et sa patte CS3 45, de manière simultanée. Chaque premier convertisseur analogique numérique 12 reçoit ainsi simultanément la commande de synchronisation sur sa patte CS 52.

Or, chaque premier convertisseur analogique numérique 12 intègre un compteur permettant de régler l'instant de la phase du premier échantillonnage. Lorsque les compteurs internes des trois premiers convertisseurs analogiques numériques 12 ont la même valeur, les trois premiers convertisseurs analogiques numériques 12 sont synchronisés en phase.

Les compteurs internes des trois premiers convertisseurs analogiques numériques 12 sont ici remis à 0 au même instant par la commande de synchronisation, de sorte que les trois premiers convertisseurs analogiques numériques 12 sont synchronisés en phase.

Le compteur 1 comporte un premier circuit de synchronisation agencé pour synchroniser en fréquence le premier échantillonnage, réalisé par chaque premier convertisseur analogique numérique 12, et le deuxième échantillonnage, réalisé par le deuxième convertisseur analogique numérique du microcontrôleur 23.

Le premier circuit de synchronisation comporte ici un bus numérique, en l'occurrence le bus SPI 50, et fonctionne de la manière suivante.

Chaque premier convertisseur analogique numérique 12 est agencé pour émettre sur le bus SPI 50 des signaux de cadence représentatifs d'une première fréquence du premier échantillonnage.

Ces signaux de cadence comprennent des impulsions. Une impulsion est générée par un premier convertisseur analogique numérique 12 lorsqu'une première valeur numérique est prête, chaque première valeur numérique résultant d'un premier échantillonnage et étant représentative de la valeur de la première tension de mesure analogique V1 numérisée par le premier convertisseur analogique numérique 12 en question (c'est-à-dire de la première tension de mesure analogique V1a pour le premier convertisseur analogique numérique 12a, de la première tension de mesure analogique V1b pour le premier convertisseur analogique numérique 12b, et de la première tension de mesure analogique V1c pour le premier convertisseur analogique numérique 12c).

Sur la fiche technique de l'ADE7912, les signaux de cadence sont appelés *DATA READY.*

Les signaux de cadence sont générés par chaque premier convertisseur analogique numérique 12 sur sa patte de disponibilité.

Or, la patte de disponibilité 55 du premier convertisseur analogique numérique 12c est reliée à la patte de cadence 57 du microcontrôleur 23.

Le microcontrôleur 23 acquiert donc les signaux de cadence sur sa patte de cadence 57, et lance le deuxième échantillonnage à partir des signaux de cadence. Les signaux de cadence génèrent en interne du microcontrôleur 23 une interruption sur front des signaux de cadence entrants, qui provoque le deuxième échantillonnage des deuxièmes tensions de mesure analogiques V2.

Le premier échantillonnage et le deuxième échantillonnage sont ainsi synchronisés en fréquence.

On note qu'il est suffisant que la patte de disponibilité 55 d'un seul premier convertisseur analogique numérique 12 (en l'occurrence, du premier convertisseur analogique numérique 12c) soit reliée à la patte de cadence 57 du microcontrôleur 23, car les trois premiers convertisseurs analogiques numériques 12 sont synchronisés entre eux en fréquence.

L'utilisation des signaux de cadence et de la patte de disponibilité 55 du premier convertisseur analogique numérique 12c est une solution très avantageuse pour réaliser « pratiquement » la synchronisation en fréquence, mais aussi particulièrement innovante, car la patte de disponibilité 55 (ou patte *CLKOUT/DREADY*) n'est en aucun cas prévue à cet effet.

Le premier circuit de synchronisation permet de synchroniser en fréquence le premier échantillonnage et le deuxième échantillonnage, mais pas en phase. Les deuxièmes tensions de mesure analogiques V2 sont échantillonnées avec un léger retard par rapport à l'échantillonnage des premières tensions de mesure analogiques V1, le léger retard produisant un déphasage de mesure entre les premières valeurs numériques et les deuxièmes valeurs numériques.

Pour compenser le déphasage de mesure et améliorer encore la précision de mesure, le compteur 1 comporte un deuxième circuit de synchronisation.

Le deuxième circuit de synchronisation permet de compenser le déphasage de mesure en déterminant un déphasage de compensation à appliquer entre les mesures de courant et les mesures de tension.

On détermine ainsi un premier déphasage de compensation $\Delta\varphi1$ pour le premier conducteur de phase, un deuxième déphasage de compensation $\Delta\varphi2$ pour le deuxième conducteur de phase, et un troisième déphasage de compensation $\Delta\varphi3$ pour le troisième conducteur de phase.

Le deuxième circuit de synchronisation comprend une mémoire dans laquelle sont stockés des paramètres de calibration. Les paramètres de calibration comprennent le premier déphasage de compensation $\Delta\varphi1$ et un premier gain de compensation K1, le deuxième déphasage de compensation $\Delta\varphi2$ et un deuxième gain de compensation K2, et le troisième déphasage de compensation $\Delta\varphi3$ et un troisième gain de compensation K3. Pour chaque conducteur de phase, le gain de compensation K permet de compenser une différence de gain due au circuit de mesure de courant 20 et au circuit de mesure de tension 21.

Les paramètres de calibration sont obtenus préalablement à la mise en service du compteur 1, c'est-à-dire au cours de sa fabrication ou de son assemblage, ou bien au moment de son installation. Puis, lorsque le compteur 1 est en opération, le microcontrôleur 23 applique le déphasage de compensation et le gain de compensation sur les premières valeurs numériques et les deuxièmes valeurs numériques associées à chaque conducteur de phase.

Pour chaque conducteur de phase, le déphasage de compensation $\Delta\varphi$ et le gain de compensation K associés sont obtenus de la manière suivante.

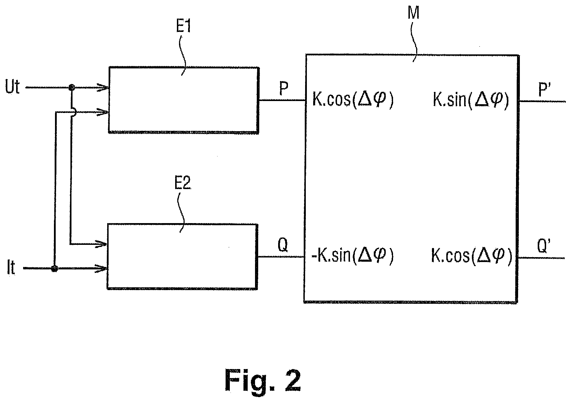

En référence à la figure 2, un courant de test It de 1A est injecté sur chaque conducteur de phase sous une tension de test Ut de 230V. Le courant de test It et la tension de test Ut sont en phase.

Le courant de test It est donc injecté en entrée du circuit de mesure de courant 20, sous la tension de test Vt qui est appliquée en entrée du circuit de mesure de tension 21.

On mesure alors, en utilisant le circuit de mesure de courant 20 et le circuit de mesure de tension 21, des valeurs de puissance active et de puissance réactive, pour obtenir une puissance active brute mesurée P (étape E1) et une puissance réactive brute mesurée Q (étape E2).

En l'absence de déphasage de mesure, la puissance active consommée devrait être égale à 230W, soit à Ut.It, et la puissance réactive à 0W.

Ainsi, en introduisant le déphasage de compensation $\Delta\varphi$, on devrait obtenir une puissance active compensée P' égale à 230W et une puissance réactive compensée Q' égale à 0W.

Or, l'introduction du déphasage de compensation $\Delta\varphi$ sur P et Q pour obtenir P' et Q' revient à réaliser la multiplication suivante :

$$\begin{pmatrix} P' \\ Q' \end{pmatrix} = M \cdot \begin{pmatrix} P \\ Q \end{pmatrix}.$$

On obtient les équations suivantes :

$$P' = K.\cos(\Delta\varphi).P + K.\sin(\Delta\varphi).Q$$

et

$$Q' = -K.\sin(\Delta\varphi).P + K.\cos(\Delta\varphi).Q,$$

où P est la puissance active brute mesurée, Q est la puissance réactive brute mesurée, P' est la puissance active compensée, telle que P'=Ut.It, où Ut est la tension de test et It le courant de test, et Q' est la puissance réactive compensée, telle que Q'=0.

Le gain de compensation K permet de compenser une différence de gain entre, d'une part, la puissance active brute mesurée P et la puissance réactive brute mesurée Q, et d'autre part, une puissance active compensée P' et une puissance réactive compensée Q'.

On a donc deux équations à deux inconnues qui permettent de déterminer $\Delta\varphi$ et K.

Ces opérations sont réalisées pour chaque conducteur de phase. On obtient ainsi le premier déphasage de compensation $\Delta\varphi1$ et le premier gain de compensation K1, le deuxième déphasage de compensation $\Delta\varphi2$ et le deuxième gain de compensation K2, et le troisième déphasage de compensation $\Delta\varphi3$ et le troisième gain de compensation K3.

Bien entendu, l'invention n'est pas limitée au mode de réalisation décrit mais englobe toute variante entrant dans le champ de l'invention telle que définie par les revendications.

Bien que le compteur présenté ici soit un compteur triphasé, l'invention s'applique bien sûr à un compteur monophasé ou à tout compteur polyphasé. Chaque conducteur de phase est alors associé à un capteur de courant et à un premier convertisseur analogique numérique, et à un capteur de tension.

Il aurait bien sûr été possible d'utiliser non pas un seul deuxième convertisseur analogique numérique, mais un deuxième convertisseur analogique numérique par conducteur de phase, tout comme il aurait été possible de n'utiliser qu'un seul premier convertisseur analogique numérique dans le cas monophasé.

Les capteurs de courant et les capteurs de tension pourraient être différents du *shunt* et du pont diviseur de tension utilisés ici.

On a décrit ici que le premier circuit de synchronisation comporte un bus numérique, en l'occurrence le bus SPI 50, et que chaque premier convertisseur analogique numérique 12 est agencé pour émettre sur le bus SPI 50 des signaux de cadence représentatifs d'une première fréquence du premier échantillonnage. Dans le cas où plusieurs premiers convertisseurs analogiques numériques sont utilisés, un seul ou bien seulement certains des premiers convertisseurs analogiques numériques pourraient émettre les signaux de cadence.

Alternativement, pour synchroniser en fréquence le premier échantillonnage et le deuxième échantillonnage, chaque deuxième convertisseur analogique numérique pourrait être agencé pour émettre sur le bus numérique des signaux de cadence représentatifs d'une deuxième fréquence du deuxième échantillonnage. Dans le cas où plusieurs deuxièmes convertisseurs analogiques numériques sont utilisés, un seul ou bien seulement certains des deuxièmes convertisseurs analogiques numériques pourraient émettre les signaux de cadence.

**Revendications**

1. Compteur d'énergie électrique (1) comportant un circuit de mesure de courant (20) agencé pour mesurer un courant de phase circulant sur un conducteur de phase d'un réseau de distribution et un circuit de mesure de tension (21) agencé pour mesurer une tension de phase sur le conducteur de phase, le circuit de mesure de courant comprenant un capteur de courant (11a) produisant une première tension de mesure analogique (V1a) représentative du courant de phase et un premier convertisseur analogique numérique (12a) agencé pour réaliser un premier échantillonnage de la première tension de mesure analogique de manière à produire des premières valeurs numériques, le circuit de mesure de tension comprenant un capteur de tension (24a) produisant une deuxième tension de mesure analogique (V2a) représentative de la tension de phase et un deuxième convertisseur analogique numérique agencé pour réaliser un deuxième échantillonnage de la deuxième tension de mesure analogique de manière à produire des deuxièmes valeurs numériques, le compteur d'énergie électrique comprenant en outre un premier circuit de synchronisation agencé pour synchroniser en fréquence le premier échantillonnage et le deuxième échantillonnage, le compteur d'énergie électrique (1) étant **caractérisé par**:
le premier circuit de synchronisation comprenant un bus numérique (50), le premier convertisseur analogique numérique (12a) étant agencé pour émettre sur le bus numérique des signaux de cadence représentatifs d'une première fréquence du premier échantillonnage, ou le deuxième convertisseur analogique numérique étant agencé pour émettre sur le bus numérique des signaux de cadence représentatifs d'une deuxième fréquence du deuxième échantillonnage.

2. Compteur d'énergie électrique selon la revendication 1, dans lequel pour synchroniser en fréquence le premier échantillonnage et le deuxième échantillonnage le premier convertisseur analogique numérique (12a) est agencé pour émettre sur le bus numérique les signaux de cadence représentatifs de la première fréquence du premier échantillonnage.

3. Compteur d'énergie électrique selon la revendication 2, dans lequel le deuxième convertisseur analogique numérique est intégré dans un composant de traitement (23) agencé pour acquérir les signaux de cadence et pour cadencer un fonctionnement du deuxième convertisseur analogique numérique à partir des signaux de cadence, de sorte qu'une deuxième fréquence du deuxième échantillonnage soit égale à la première fréquence.

4. Compteur d'énergie électrique selon la revendication 3, le compteur d'énergie électrique étant un compteur polyphasé relié à une pluralité de conducteurs de phase, le compteur d'énergie électrique comprenant un capteur de courant et un premier convertisseur analogique numérique associés à chaque conducteur de phase, les premiers convertisseurs analogiques numériques étant synchronisés en fréquence et en phase par le composant de traitement (23) via le bus numérique (50).

5. Compteur d'énergie électrique selon la revendication 2, dans lequel les signaux de cadence comprennent des impulsions, chaque impulsion étant générée lorsqu'une première valeur numérique est prête.

6. Compteur d'énergie électrique selon l'une des revendications précédentes, comprenant en outre un deuxième circuit de synchronisation agencé pour synchroniser en phase le premier échantillonnage et le deuxième échantillonnage.

7. Compteur d'énergie électrique selon la revendication 6, dans lequel le deuxième circuit de synchronisation comprend une mémoire dans laquelle sont stockés des paramètres de calibration comprenant un déphasage de compensation

($\Delta\varphi$) à appliquer entre les premières valeurs numériques et les deuxièmes valeurs numériques.

8. Compteur d'énergie électrique selon la revendication 7, dans lequel les paramètres de calibrations sont obtenus en injectant un courant de test (It) en entrée du circuit de mesure de courant (20), sous une tension de test (Ut) appliquée en entrée du circuit de mesure de tension (21), en mesurant des valeurs de puissance active et de puissance réactive pour obtenir une puissance active brute mesurée (P) et une puissance réactive brute mesurée (Q), et en estimant le déphasage de compensation à partir de la puissance active brute mesurée et de la puissance réactive brute mesurée.

9. Compteur d'énergie électrique selon la revendication 8, dans lequel les paramètres de calibration comprennent de plus un gain de compensation (K) permettant de compenser une différence de gain entre, d'une part, la puissance active brute mesurée (P) et la puissance réactive brute mesurée (Q), et d'autre part, une puissance active compensée (P') et une puissance réactive compensée (Q').

10. Compteur d'énergie électrique selon la revendication 9, dans lequel les paramètres de calibration sont obtenus en utilisant les équations suivantes :

$$P' = K.\cos(\Delta\varphi).P + K.\sin(\Delta\varphi).Q$$

et

$$Q' = -K.\sin(\Delta\varphi).P + K.\cos(\Delta\varphi).Q,$$

où P est la puissance active brute mesurée, Q est la puissance réactive brute mesurée, P' est la puissance active compensée, telle que P'=Ut.It, où Ut est la tension de test et It le courant de test, Q' est la puissance réactive compensée, telle que Q'=0, $\Delta\varphi$ est le déphasage de compensation et K est le gain de compensation.

11. Compteur d'énergie électrique selon l'une des revendications précédentes, dans lequel le circuit de mesure de courant (20) comprend un module de mesure de courant qui comprend le capteur de courant (11a) et qui est isolé électriquement du circuit de mesure de tension (21) .

12. Compteur d'énergie électrique selon la revendication 11, dans lequel une isolation électrique entre le module de mesure de courant et le circuit de mesure de tension est assurée par une barrière d'isolation (18) intégrée dans le premier convertisseur analogique numérique (12a).

13. Compteur d'énergie électrique selon l'une des revendications précédentes, le capteur de courant comprenant un *shunt* et le capteur de tension comprenant un pont diviseur de tension.

**Patentansprüche**

1. Stromzähler (1), umfassend eine Strommessschaltung (20), die ausgebildet ist, einen Phasenstrom, der in einem Phasenleiter eines Verteilungsnetzes fließt, zu messen, und eine Spannungsmessschaltung (21), die ausgebildet ist, eine Phasenspannung auf dem Phasenleiter zu messen, wobei die Strommessschaltung einen Stromsensor (11a) umfasst, der eine erste analoge Messspannung (V1a) erzeugt, die repräsentativ für den Phasenstrom ist, und einen ersten Analog-Digital-Umsetzer (12a), der ausgebildet ist, eine erste Probenahme der ersten analogen Messspannung durchzuführen, um erste digitale Werte zu erzeugen, wobei die Spannungsmessschaltung einen Spannungssensor (24a) umfasst, der eine zweite analoge Messspannung (V2a) erzeugt, die repräsentativ für die Phasenspannung ist, und einen zweiten Analog-Digital-Umsetzer, der ausgebildet ist, eine zweite Probenahme der zweiten analogen Messspannung durchzuführen, um zweite digitale Werte zu erzeugen, wobei der Stromzähler ferner eine erste Synchronisationsschaltung umfasst, die ausgebildet ist, die erste Probenahme und die zweite Probenahme in der Frequenz zu synchronisieren, wobei der Stromzähler (1) **dadurch gekennzeichnet ist, dass**: die erste Synchronisationsschaltung einen digitalen Bus (50) umfasst, der erste Analog-Digital-Umsetzer (12a) ausgebildet ist, auf den digitalen Bus Taktsignale zu senden, die repräsentativ für eine erste Frequenz der ersten Probenahme sind, oder der zweite Analog-Digital-Umsetzer ausgebildet ist, auf den digitalen Bus Taktsignale zu senden, die repräsentativ für eine zweite Frequenz der zweiten Probenahme sind.

**2.** Stromzähler nach Anspruch 1, bei dem zum Synchronisieren der ersten Probenahme und der zweiten Probenahme in der Frequenz der erste Analog-Digital-Umsetzer (12a) ausgebildet ist, auf den digitalen Bus die Taktsignale zu senden, die repräsentativ für die erste Frequenz der ersten Probenahme sind.

**3.** Stromzähler nach Anspruch 2, bei dem der zweite Analog-Digital-Umsetzer in eine Verarbeitungskomponente (23) integriert ist, die ausgebildet ist, die Taktsignale zu erfassen und einen Betrieb des zweiten Analog-Digital-Umsetzers anhand der Taktsignale zu takten, derart, dass eine zweite Frequenz der zweiten Probenahme gleich der ersten Frequenz ist.

**4.** Stromzähler nach Anspruch 3, wobei der Stromzähler ein Mehrphasenzähler ist, der mit einer Vielzahl von Phasenleitern verbunden ist, wobei der Stromzähler einen Stromsensor und einen ersten Analog-Digital-Umsetzer umfasst, die mit jedem Phasenleiter verbunden sind, wobei die ersten Analog-Digital-Umsetzer durch die Verarbeitungskomponente (23) über den digitalen Bus (50) in der Frequenz und in der Phase synchronisiert sind.

**5.** Stromzähler nach Anspruch 2, bei dem die Taktsignale Pulse umfassen, wobei jeder Puls erzeugt wird, wenn ein erster digitaler Wert bereit ist.

**6.** Stromzähler nach einem der vorhergehenden Ansprüche, ferner umfassend eine zweite Synchronisationsschaltung, die ausgebildet ist, die erste Probenahme und die zweite Probenahme in der Phase zu synchronisieren.

**7.** Stromzähler nach Anspruch 6, bei dem die zweite Synchronisationsschaltung einen Speicher umfasst, in dem Kalibrierungsparameter gespeichert sind, die eine Kompensationsphasenverschiebung ($\Delta\phi$) zur Anwendung zwischen den ersten digitalen Werten und den zweiten digitalen Werten umfassen.

**8.** Stromzähler nach Anspruch 7, bei dem die Kalibrierungsparameter erhalten werden, indem ein Teststrom (It) am Eingang der Strommessschaltung (20) injiziert wird, bei einer Testspannung (Ut), die am Eingang der Spannungsmessschaltung (21) angelegt wird, indem Werte der Wirkleistung und der Blindleistung gemessen werden, um eine gemessene Bruttowirkleistung (P) und eine gemessene Bruttoblindleistung (Q) zu erhalten, und indem die Kompensationsphasenverschiebung anhand der gemessenen Bruttowirkleistung und der gemessenen Bruttoblindleistung geschätzt wird.

**9.** Stromzähler nach Anspruch 8, bei dem die Kalibrierungsparameter ferner einen Kompensationsgewinn (K) umfassen, der ein Kompensieren einer Gewinndifferenz zwischen der gemessenen Bruttowirkleistung (P) und der gemessenen Bruttoblindleistung (Q) einerseits und einer kompensierten Wirkleistung (P') und einer kompensierten Blindleistung (Q') andererseits ermöglicht.

**10.** Stromzähler nach Anspruch 9, bei dem die Kalibrierungsparameter erhalten werden, indem die folgenden Gleichungen verwendet werden:

$$P' = K.cos(\Delta\phi).P + K.sin(\Delta\phi).Q$$

und

$$Q' = -K.sin(\Delta\phi).P + K.cos(\Delta\phi).Q,$$

wobei P die gemessene Bruttowirkleistung ist, Q. die gemessene Bruttoblindleistung ist, P' die kompensierte Wirkleistung ist, sodass P'=Ut.It, wobei Ut die Testspannung und It der Teststrom ist, Q' die kompensierte Blindleistung ist, sodass Q'=0, $\Delta\phi$ die Kompensationsphasenverschiebung und K der Kompensationsgewinn ist.

**11.** Stromzähler nach einem der vorhergehenden Ansprüche, bei dem die Strommessschaltung (20) ein Strommessmodul umfasst, das den Stromsensor (11a) umfasst und das von der Spannungsmessschaltung (21) elektrisch isoliert ist.

**12.** Stromzähler nach Anspruch 11, bei dem eine elektrische Isolierung zwischen dem Strommessmodul und der Spannungsmessschaltung durch eine Isolierungsbarriere (18) sichergestellt ist, die in den ersten Analog-Digital-Umsetzer (12a) integriert ist.

**13.** Stromzähler nach einem der vorhergehenden Ansprüche, wobei der Stromsensor einen Shunt und der Spannungssensor eine Spannungsteilerbrücke umfasst.

**Claims**

**1.** An electricity meter (1) comprising a current-measurement circuit (20) arranged to measure a phase current flowing in a phase conductor of a distribution network and a voltage-measurement circuit (21) arranged to measure a phase voltage on the phase conductor, the current-measurement circuit comprising a current sensor (11a) producing a first analog measurement voltage (V1a) representative of the phase current and a first analog-to-digital converter (12a) arranged to take first samples of the first analog measurement voltage so as to produce first digital values, the voltage-measurement circuit comprising a voltage sensor (24a) producing a second analog measurement voltage (V2a) representative of the phase voltage and a second analog-to-digital converter arranged to take second samples of the second analog measurement voltage so as to produce second digital values, the electricity meter further comprising a first synchronization circuit arranged to synchronize in frequency the taking of the first samples and of the second samples,
the electricity meter (1) being **characterized by**:
the first synchronization circuit comprising a digital bus (50), the first analog-to-digital converter (12a) being arranged to issue, on the digital bus, timing signals representative of a first frequency for taking the first samples, or the second analog-to-digital converter being arranged to issue, on the digital bus, timing signals representative of a second frequency for taking the second samples.

**2.** An electricity meter according to claim 1, wherein, in order to synchronize in frequency the taking of the first samples and of the second samples, the first analog-to-digital converter (12a) is arranged to issue, on the digital bus, the timing signals representative of the first frequency for taking the first samples.

**3.** An electricity meter according to claim 2, wherein the second analog-to-digital converter is integrated in a processor component (23) arranged to acquire the timing signals and to control the timing of the operation of the second analog-to-digital converter on the basis of the timing signals, such that a second frequency for taking the second samples is equal to the first frequency.

**4.** An electricity meter according to claim 3, the electricity meter being a polyphase meter connected to a plurality of phase conductors, the electricity meter comprising a respective current sensor and a respective first analog-to-digital converter that are associated with each phase conductor, the first analog-to-digital converters being synchronized in frequency and in phase by the processor component (23) via the digital bus (50).

**5.** An electricity meter according to claim 2, wherein the timing signals comprise pulses, each pulse being generated when a first digital value is ready.

**6.** An electricity meter according to any preceding claim, further comprising a second synchronization circuit arranged to synchronize in phase the taking of the first samples and of the second samples.

**7.** An electricity meter according to claim 6, wherein the second synchronization circuit includes a memory storing calibration parameters comprising a compensation phase offset ($\Delta\varphi$) for application between the first digital values and the second digital values.

**8.** An electricity meter according to claim 7, wherein the calibration parameters are obtained by injecting a test current (It) as input to the current-measurement circuit (20) at a test voltage (Ut) applied as input to the voltage-measurement circuit (21), by measuring active and reactive power values in order to obtain a measured raw active power (P) and a measured raw reactive power (Q), and by estimating the compensation phase offset from the measured raw active power and the measured raw reactive power.

**9.** An electricity meter according to claim 8, wherein the calibration parameters further comprise a compensation gain (K) serving to compensate a gain difference between firstly the measured raw active power (P) and the measured raw reactive power (Q), and secondly a compensated active power (P') and a compensated reactive power (Q').

**10.** An electricity meter according to claim 9, wherein the calibration parameters are obtained by using the following equations:

$$P' = K.\cos(\Delta\varphi).P + K.\sin(\Delta\varphi).Q$$

and

$$Q' = -K.\sin(\Delta\varphi).P + K.\cos(\Delta\varphi).Q,$$

where P is the measured raw active power, Q is the measured raw reactive power, P' is the compensated active power, such that P'=Ut.It, where Ut is the test voltage and It is the test current, Q' is the compensated reactive power, such that Q'=0, $\Delta\varphi$ is the compensation phase offset, and K is the compensation gain.

11. An electricity meter according to any preceding claim, wherein the current measurement circuit (20) includes a current-measurement module that includes the current sensor (11a) and that is electrically isolated from the voltage-measurement circuit (21).

12. An electricity meter according to claim 11, wherein electrical isolation between the current-measurement module and the voltage-measurement circuit is obtained by an isolation barrier (18) integrated in the first analog-to-digital converter (12a).

13. An electricity meter according to any preceding claim, the current sensor comprising a shunt and the voltage sensor comprising a voltage divider bridge.

Fig. 1

**Fig. 2**

**RÉFÉRENCES CITÉES DANS LA DESCRIPTION**

**Documents brevets cités dans la description**

- US 2008215262 A1